# EUROPEAN PATENT SPECIFICATION

(11) **EP 4 525 031 B1**
(45) Date of publication and mention of the grant of the patent: **11.03.2026**
(21) Application number: 24199255.1
(22) Date of filing: 09.09.2024
(51) Int. Cl.: H01L 21/768, H01L 23/532

(54) **SEMICONDUCTOR WAFER FABRICATION WITH POLYIMIDE TO GRAPHENE CONVERSION**
HERSTELLUNG VON HALBLEITERWAFERN MIT POLYIMID-GRAPHEN-UMWANDLUNG
FABRICATION DE PLAQUETTES SEMI-CONDUCTRICES AVEC CONVERSION DE POLYIMIDE EN GRAPHÈNE

(30) Priority: 18.09.2023 US 202318369755
(43) Date of publication of application: 19.03.2025
(73) Proprietor: NXP USA, Inc., Austin, TX 78735 (US)
(72) Inventor: Reber, Douglas Michael, 5656AG Eindhoven (NL)
(74) Representative: Hardingham, Christopher Mark

(56) References cited:
- CN-A- 115 101 505
- US-A1- 2013 015 583

## Description

### BACKGROUND OF THE INVENTION

### Field of the Invention

The present disclosure is directed in general to the field of semiconductor devices. In one aspect, the present disclosure relates to inter-level interconnect structures formed on semiconductor devices.

### Description of the Related Art

Modern integrated circuits typically have conductors formed on multiple interconnect layers or levels to accommodate dense circuitry. These conductors can be used to transfer information in the form of signals sent to and from integrated circuitry formed on an underlying substrate. After forming the integrated circuitry on the substrate during Front-End of Line (FEOL) processing, existing semiconductor wafer fabrication techniques form inter-level interconnect structures by repetitively performing deposit, etch, plating and polishing steps with a variety of different layers and materials, all of which make the interconnect fabrication process complex, time-consuming and expensive. In recent years, copper has been used to form inter-layer interconnects, but as semiconductor fabrication processes advance toward future nodes with shrinking interconnect stacks, there are increasingly resistance and capacitance issues which arise with the materials used to form interconnects. In addition, with higher performance demands, signals traversing the interconnect conductors operate at very high frequencies, but the smaller spacing between interconnect geometries can cause increased parasitic capacitance which adversely impacts the speed and power of integrated circuits. Another negative aspect of increased parasitic capacitance can be increased signal crosstalk between adjacent and parallel conductors. Thus, existing interconnect fabrication processes have not provided the cost, speed, and electrical performance required for leading edge integrated circuit devices. Further limitations and disadvantages of conventional processes and technologies will become apparent to one of skill in the art after reviewing the remainder of the present application with reference to the drawings and detailed description which follow.

The publication CN 115 101 505 A discloses a method of forming conductive vias in a polyimide film by laser-induced conversion of the polyimide into graphene.

### BRIEF DESCRIPTION OF THE DRAWINGS

The present invention may be understood, and its numerous objects, features and advantages obtained, when the following detailed description of a preferred embodiment is considered in conjunction with the following drawings.
Figures 1-8 illustrate cross-sectional views at different stages of manufacture of a semiconductor structure having graphene interconnect structures formed using a single inlaid selective polyimide-to-graphene conversion process in accordance with selected embodiments of the present disclosure.
Figure 9 illustrates a simplified process flow fabricating a graphene interconnect structure in accordance with selected embodiments of the present disclosure.

### DETAILED DESCRIPTION

An integrated circuit fabrication process and resulting integrated circuit are described for fabricating graphene interconnect structures. In selected embodiments, the graphene interconnect structures are formed using a selective polyimide-to-graphene conversion process. For example, a semiconductor wafer may be processed to form a plurality of integrated circuits on a substrate and then covered with a protective interlayer dielectric (ILD) layer and a first level metal or graphene layer (M1). After forming a planarized ultra-low k (ULK) dielectric layer over the first level metal or graphene layer (M1), a via etch opening and next level metal line opening are sequentially etched into the upper surface of the planarized ULK dielectric layer to expose the first level metal or graphene layer (M1), and then filled with one or more planarized polyimide layers. By selectively applying a laser beam at the appropriate energy dose and intensity, the one or more planarized polyimide layers may be converted into a graphene foam interconnect structure. For example, a laser ranging from infrared, ultraviolet, or visible ranges may be employed to directly lase polyimide (PI) plastic films into 3D porous graphene material as a one-step method without the need for high-temperature reaction conditions, solvent, or subsequent treatments. By directly forming the graphene foam interconnect structures from the polyimide layer(s) using a laser energy source, no additional barrier layers or liner layers are required, such as are used with nickel or copper-based interconnects.

In this disclosure, an improved integrated circuit design, structure, and method of manufacture are described for forming graphene interconnect structures as part of the middle-end-of-line or back-end-of-line process to address various problems in the art where various limitations and disadvantages of conventional solutions and technologies will become apparent to one of skill in the art after reviewing the remainder of the present application with reference to the drawings and detailed description provided herein. Various illustrative embodiments of the present invention will now be described in detail with reference to the accompanying figures. While various details are set forth in the following description, it will be appreciated that the present invention may be practiced without these specific details, and that numerous implementation-specific decisions may be made to the invention described herein to achieve the device designer's specific goals, such as compliance with process technology or design-related constraints, which will vary from one implementation to another. While such a development effort might be complex and time-consuming, it would nevertheless be a routine undertaking for those of ordinary skill in the art having the benefit of this disclosure. For example, selected aspects are depicted with reference to simplified cross sectional drawings of a semiconductor device without including every device feature or geometry in order to avoid limiting or obscuring the present invention. Such descriptions and representations are used by those skilled in the art to describe and convey the substance of their work to others skilled in the art. It is also noted that, throughout this detailed description, certain elements in the figures are illustrated for simplicity and clarity and have not necessarily been drawn to scale. In addition, the dimensions of some of the elements in the figures may be exaggerated relative to other elements to help improve the understanding of the embodiments of the present disclosure. Further, reference numerals have been repeated among the drawings to represent corresponding or analogous elements. In addition, the depicted device layers that are shown as being deposited and/or etched are represented with simplified line drawings, though it will be appreciated that, in reality, the actual contours or dimensions of device layers will be non-linear, such as when the described etch processes are applied at different rates to different materials, or when the described deposition or growth processes generate layers based on the underlaying materials.

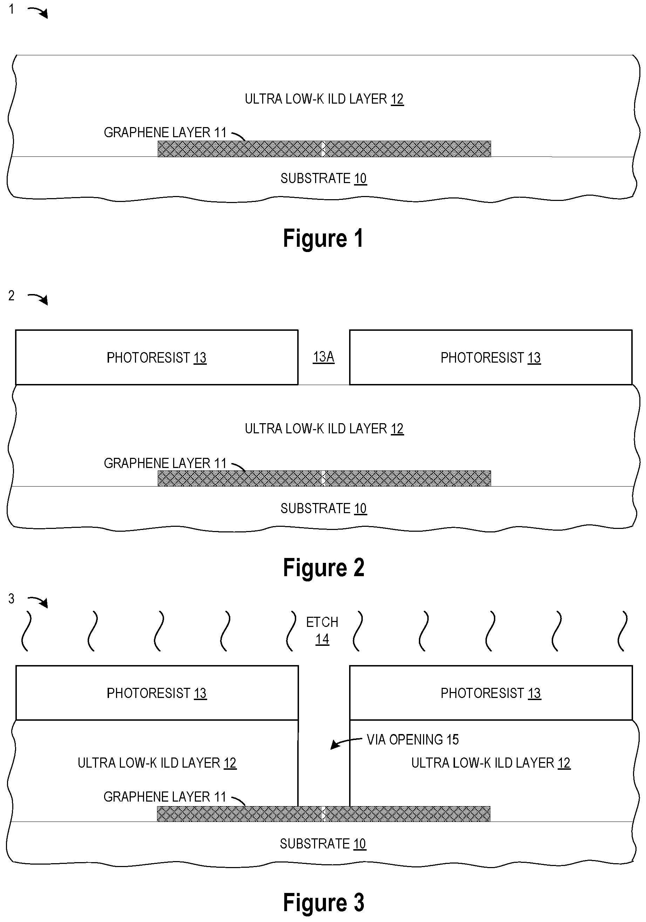

Various illustrative embodiments of the present invention will now be described in detail with reference to Figures 1-9. In addition, although specific example materials, thicknesses, and processes are described herein, those skilled in the art will recognize that other materials, thicknesses, and processes with similar properties or characteristics can be substituted without loss of function. It is noted that, throughout this detailed description, certain layers of materials will be deposited and removed to form the semiconductor structure. Where the specific procedures for processing such layers or thicknesses of such layers are not detailed below, conventional techniques known to one skilled in the art for depositing, removing, forming, or otherwise processing such layers at appropriate thicknesses shall be intended. Such details are well known and not considered necessary to teach one skilled in the art how to make or use the present invention.

Turning now to Figure 1, there is illustrated in cross-sectional form a portion of a semiconductor structure 1 having a first inter-layer dielectric (ILD1) layer 12 and a first metal line conductor layer 11 formed over a substrate 10 in which one or more integrated circuit elements (not shown) are formed. As will be appreciated, the integrated circuit elements may include one or more transistors, resistors, capacitors, diodes, or other semiconductor components that are formed on or in a semiconductor substrate that can be formed with any suitable semiconductor material or combinations of materials, such as gallium arsenide, silicon germanium, semiconductor-on-insulator (SOI), silicon, monocrystalline silicon, and the like. To protect the integrated circuit elements, the substrate 10 also includes an initial insulating layer (not shown) which may be formed with any suitable insulating material. For example, a planarized boro-phosphorous tetra-ethyl ortho-silicate (BPTEOS) layer may form all or part of an initial inter-layer dielectric (ILD0) layer that provides a gettering function to help protect integrated circuit elements and to control the field leakage between semiconductor transistors.

After forming the initial ILD0 layer, the first metal line (M1) conductor layer 11 may be formed with any suitable material, such as a copper material, a silver material, an aluminum material, a graphene material, or the like. For example, the M1 conductor layer 11 may be formed as a graphene layer that surrounds a patterned metal layer that is formed with nickel or other suitable metal material which is exposed to a growth process using a carbon-containing film such as acetylene or other carbon-containing gas. The carbon-containing gas may be part of a plasma, remote plasma, or chemical reaction process such that elemental carbon or carbon ions interact with the nickel. As the carbon diffuses through the nickel, it forms graphene on the outer surfaces of the nickel until such time as the carbon reaches its solid solubility limit in nickel. Excess carbon, which may not be in graphene form, such as graphite, is removed chemically, such as with the use of a plasma etch. Alternatively, to form the graphene layer 11, the patterned metal layer may be exposed to a plasma with some hydrogen and controlled amounts of methane, or may be exposed to a carbon-containing paste. Alternatively, graphene layer 11 may be formed by using a laser-induced graphene technique described more fully hereinbelow to convert a polyimide layer directly into graphene foam structure without requiring a patterned metal layer.

After forming the M1 conductor layer 11, the first ILD1 layer 12 may be formed over the semiconductor structure to a predetermined thickness using any suitable deposition technique, such as chemical vapor deposition (CVD), plasma-enhanced chemical vapor deposition (PECVD), physical vapor deposition (PVD), atomic layer deposition (ALD), atmospheric pressure CVD (AP-CVD), chemical bath deposition (CBD), or any combination(s) of the above. For example, the first ILD1 layer 12 may be formed with an ultra-low-k (ULK) dielectric material having a dielectric constant k value of less than about 2.5. Example ULK materials include, but are not limited to fluorinated amorphous diamond-like carbon (a-C:F), carbon-doped SiO₂, Parvlene-F, Bezocycloutane (BCB), Teflon AF, or another similar ultra-low k dielectric.

Figure 2 illustrates processing of the semiconductor structure 2 subsequent to Figure 1 after forming a first patterned photoresist or hard mask layer 13 on the semiconductor structure in accordance with selected embodiments of the present disclosure. While any suitable photoresist patterning process may be used, the first patterned photoresist mask 13 may be formed on the first ILD1 layer 12 by depositing, patterning, etching or developing a photoresist layer formed with any material that is suitable for photolithography. As depicted, the first patterned photoresist or hard mask layer 13 includes a defined opening 13A which exposes the underlying first ILD1 layer 12 at an intended etch location for forming a via etch opening over the depicted graphene layer 11.

Figure 3 illustrates processing of the semiconductor structure 3 subsequent to Figure 2 after one or more etch processes 14 are applied to create the via etch opening 15 in accordance with selected embodiments of the present disclosure. While any suitable etch process(es) may be used, the etch processing 14 can include using the first patterned photoresist mask 13 to perform a reactive-ion etching (RIE) step having suitable etch chemistry properties to remove the exposed portions of the underlying first ILD1 layer 12. For example, a controlled photo etch process 14, such as a timed anisotropic dry etch, may be used to remove a portion of the exposed portions of the underlying first ILD1 layer 12 to a predetermined depth which exposes the underlying graphene layer 11. While the sidewalls of the via etch opening 15 are substantially vertical, it will be appreciated that minor deviations in the sidewall profile may occur due to etch processing variations.

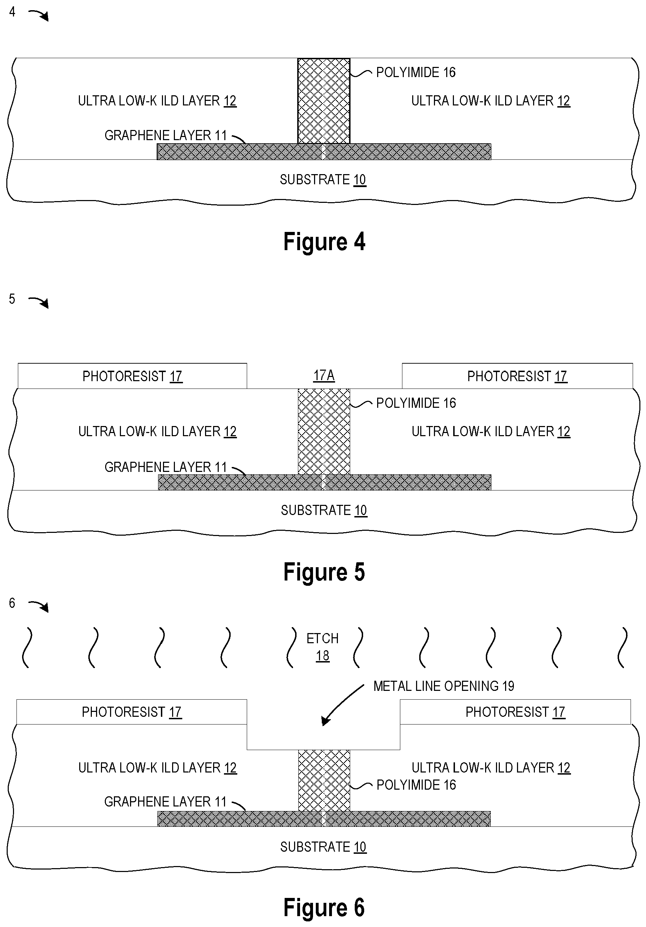

Figure 4 illustrates processing of the semiconductor structure 4 subsequent to Figure 3 after forming a first polyimide layer 16 in the defined via etch opening 15 in accordance with selected embodiments of the present disclosure. While any suitable formation process may be used, the first polyimide layer 16 may be formed after stripping or removing the first patterned photoresist layer 13, and then using a damascene or inlaid process to form the first polyimide layer 16 to make direct contact with the underlying graphene layer 11. For example, the first polyimide layer 16 may be deposited with a spin-coating process or otherwise formed over the semiconductor structure to completely fill the via etch opening 15 along with the upper horizontal surfaces of the first ILD1 layer 12. Example polyimide materials include, but are not limited to, fluorinated polyimide (PI-FP, PI-FO and PI-FH) films which may be prepared using a polycondensation reaction method by incorporating p-phenylenediamine (PDA), 4-40-diaminodiphenyl ether (ODA) and 4,40-(Hexafluoroisopropylidene) bis (p-phenyleneoxy) dianiline (HFPBDA) into 4,40-(Hexafluoroisopropylidene) diphthalic anhydride (6FDA), respectively. In other embodiments, the first polyimide layer 16 is formed with a material having chemical properties which interact with laser irradiation to directly form graphene. After depositing the first polyimide layer 16 to fill the via etch opening 15, a planarization process is applied, such as chemical-mechanical polishing (CMP), to remove excess polyimide material from the upper horizontal surfaces of the first ILD1 layer 12, thereby planarizing the first polyimide layer 16.

Figure 5 illustrates processing of the semiconductor structure 5 subsequent to Figure 4 after forming a second patterned photoresist or hard mask layer 17 on the semiconductor structure in accordance with selected embodiments of the present disclosure. While any suitable photoresist patterning process may be used, the second patterned photoresist mask 17 may be formed on the first ILD1 layer 12 by depositing, patterning, etching or developing a suitable photoresist material to define an opening 17A which exposes an intended etch location for forming a metal line in the underlying polyimide layer 16 and first ILD1 layer 12.

Figure 6 illustrates processing of the semiconductor structure 6 subsequent to Figure 5 after one or more etch processes 18 are applied to create the metal line opening 18 in accordance with selected embodiments of the present disclosure. While any suitable etch process(es) may be used, the etch processing 18 can include using the second patterned photoresist mask 17 to perform a reactive-ion etching (RIE) step having suitable etch chemistry properties to remove the exposed portions of the underlying polyimide layer 16 and first ILD1 layer 12. For example, a controlled photo etch process 18, such as a timed anisotropic dry etch, may be used to remove a portion of the exposed portions of the polyimide layer 16 and first ILD1 layer 12 to a predetermined depth which exposes the underlying first polyimide layer 16. While the sidewalls of the metal line opening 19 are substantially vertical, it will be appreciated that minor deviations in the sidewall profile may occur due to etch processing variations.

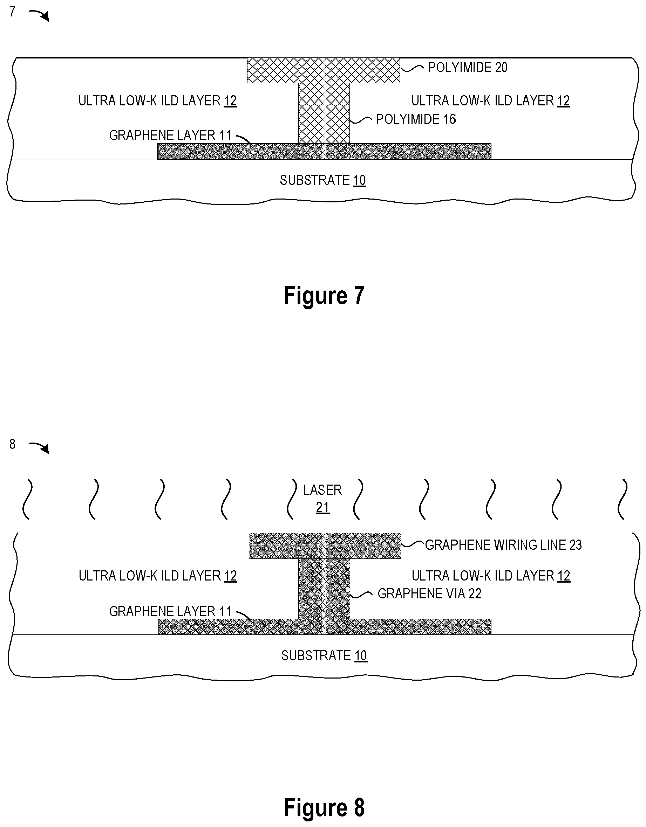

Figure 7 illustrates processing of the semiconductor structure 7 subsequent to Figure 6 after forming a second polyimide layer 20 in the defined metal line opening 19 in accordance with selected embodiments of the present disclosure. While any suitable formation process may be used, the second polyimide layer 20 may be formed after stripping or removing the second patterned photoresist layer 17, and then using a damascene or inlaid process to form the second polyimide layer 20 to make direct contact with the underlying first polyimide layer 16. For example, the second polyimide layer 20 may be formed by depositing with a spin-coating process or otherwise forming any suitable polyimide material over the semiconductor structure to completely fill the metal line opening 19 along with the upper horizontal surfaces of the first ILD1 layer 12. After depositing the second polyimide layer 20 to fill the metal line opening 19, a planarization process is applied to remove excess polyimide material from the upper horizontal surfaces of the first ILD1 layer 12, thereby planarizing the second polyimide layer 20.

Figure 8 illustrates processing of the semiconductor structure 8 subsequent to Figure 7 after applying a laser irradiation source 21 to directly convert the first and second polyimide layers 16, 20 into, respectively, a graphene via structure 22 and graphene wiring line 23, thereby forming a graphene interconnect structure 22-23 in accordance with selected embodiments of the present disclosure. While any suitable laser irradiation source 21 process may be used, the lasers ranging from infrared, ultraviolet, and visible ranges may be employed to provide a laser-induced graphene process which synthesizes the graphene interconnect structure 22-23. For example, an ultraviolet laser may be employed to directly lase polyimide (PI) plastic films into 3D porous graphene material as a one-step method without the need for high-temperature reaction conditions, solvent, or subsequent treatments. Since the first and second polyimide layers 16, 20 have different depth profiles in the first ILD1 layer 12, the application of the laser irradiation source 21 should be controlled to selectively apply the required energy dosage for converting both the first and second polyimide layers 16, 20 into graphene. For example, the laser scanning operations may be controlled to apply a first set of laser pulses which are positioned with sufficient energy to convert the entirety of the first polyimide layer 16 into the graphene via structure 22, and to apply a second set of laser pulses which are positioned with sufficient energy to convert the entirety of the second polyimide layer 20 into the graphene wiring line structure 23. By properly constructing the first ILD1 layer 12 with a material that is not reactive to the laser irradiation source 21, the graphene interconnect structures 22-23 are selectively formed in the semiconductor structure 8 to provide reduced electrical resistivity and processing complexity as compared to existing techniques which use metal conductors (e.g., copper or nickel) to form the conductive interconnect structures.

As disclosed hereinabove, a single inlaid interconnect process may be used to separately form and fill the via etch opening 15 and the metal line opening 19. However, other embodiments of the present disclosure may use a dual inlaid interconnect process whereby a via etch opening and the metal line opening are sequentially formed in the first ILD1 layer 12, and then subsequently filled with one or more polyimide layers using a single deposition step, followed by a planarization or CMP step to planarize the deposited polyimide layer(s). In yet other embodiments, the planarization or CMP step can occur after forming the graphene interconnect structure(s).

As will be appreciated, the graphene interconnect fabrication sequence described hereinabove may be repeated one or more times to form multiple graphene interconnect layers or levels over the substrate 10. For example, a second graphene interconnect structure may be formed in a second inter-layer dielectric (ILD2) layer that is formed on the first ILD ILD1 layer by selectively etching a via etch opening and next level metal line opening in the second ILD2 layer which expose the graphene interconnect structures 22-23, filling the via etch opening and next level metal line opening with one or more polyimide layers, and then selectively applying a laser beam at the appropriate energy dose and intensity to directly convert the one or more polyimide layers into the second graphene interconnect structure.

The last or topmost metal layers in the semiconductor structure can be formed with any conductive material, such as laser-induced graphene, aluminum, copper, tantalum, tungsten, tantalum nitride, tungsten nitride, titanium, titanium nitride, or the like and combinations of the above. As formed, each of the last metal layers is coupled to one or more integrated circuit elements (not shown) in the substrate 10 via the intervening graphene interconnect structures (e.g., 22, 23) formed within ILD layers of an interconnect stack which may be formed with any insulating material. While the specific arrangement, construction, and connection of the different conductive interconnect layers is not important, each may be constructed within a constituent ILD layer in the interconnect stack by using a damascene process to form polyimide structures which are converted with laser irradiation pulses into graphene structures as disclosed herein.

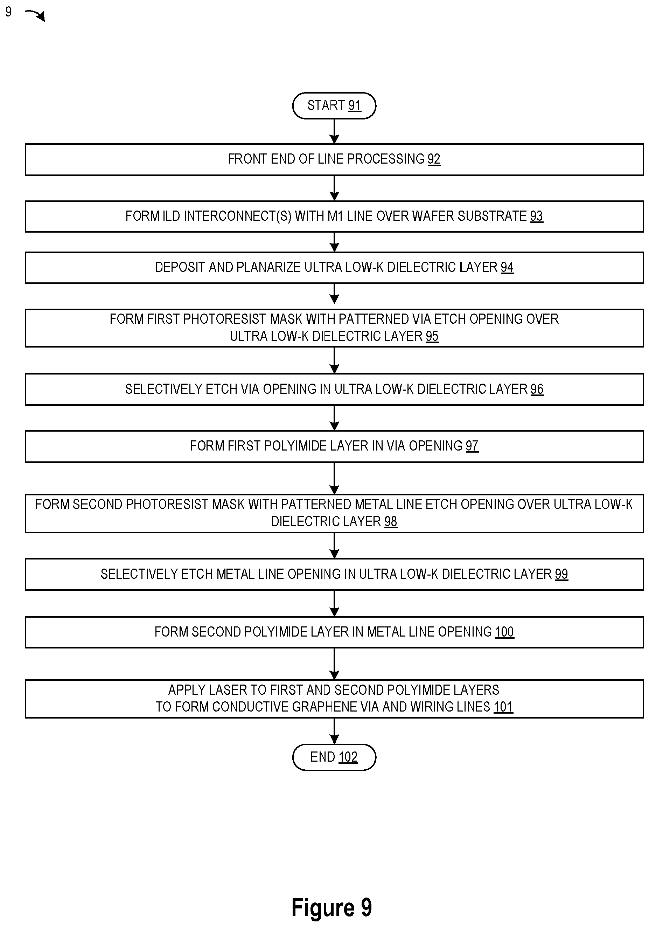

Turning now to Figure 9, there is illustrated a simplified process flow 9 for fabricating a graphene interconnect structure in accordance with selected embodiments of the present disclosure. Though selected embodiments of the graphene interconnect fabrication methodology are described with reference to an example back-end-of-line fabrication process, it will be appreciated by persons skilled in the art that the sequence of illustrated steps may be used in any suitable stage of the device fabrication process, and may be modified, reduced or augmented in keeping with the disclosure of the present invention. Thus, it will be appreciated that the methodology of the present disclosure may be thought of as performing the identified sequence of steps in the order depicted in Figure 9, though the steps may also be performed in parallel, in a different order, or as independent operations that are combined.

After starting at step 91, the disclosed fabrication methodology begins with one or more front-end-of-line (FEOL) processing steps 92 which are used to fabricate one or more integrated circuit elements (e.g., transistors, capacitors, resistors, diodes, etc.) in a wafer substrate. Generally speaking, FEOL processing is the first portion of IC fabrication where the individual components (transistors, capacitors, resistors, etc.) are patterned in the semiconductor, and generally covers everything up to (but not including) the deposition of metal interconnect layers.

At step 93, one or more first ILD interconnects are formed over the wafer substrate with an attached first metal (M1) line. An example first ILD interconnect may include an initial interlayer dielectric (ILD0) layer that is formed over the integrated circuit elements by depositing, spin-coating, or otherwise forming a silicon dioxide layer. In the initial ILD0 layer, a contact may be formed to extend through the initial ILD0 layer to a terminal of an integrated circuit element (e.g., a source/drain region of a transistor device), such as be selectively etching a contact opening and then filling the opening with one or more conductive via layers. In contact with the contact, a first metal (M1) layer may be selectively formed over the initial ILD0 layer, such as by depositing a conductive metal layer over the wafer substrate that is subsequently patterned and etched to leave the M1 layer. In other embodiments, the M1 layer may be formed by selectively etching a metal line etch opening in the initial ILD0 layer, filling the metal line etch opening with one or more polyimide layers, and then selectively applying a laser beam at the appropriate energy dose and intensity to directly convert the one or more polyimide layers into a graphene M1 metal line layer.

At step 94, an ultra low-k (ULK) dielectric layer is deposited and planarized over the wafer substrate. An example ULK dielectric layer may be formed with a dielectric material having a dielectric constant k value of less than about 2.5 that is formed to a predetermined thickness using any suitable deposition technique, such as CVD, PECVD, PVD, ALD, AP-CVD, CBD, or any combination(s) of the above. Example ULK materials include, but are not limited to fluorinated amorphous diamond-like carbon (a-C:F), carbon-doped SiO₂, Parvlene-F, Bezocycloutane (BCB), Teflon AF, or another similar ultra-low k dielectric. In other embodiments, the ULK dielectric layer may be replaced with a dielectric material having a dielectric constant k value that is less than about 3.9.

At step 95, a first photoresist mask with a patterned via etch opening is formed over the ultra low-k dielectric layer. In selected embodiments, the first photoresist mask is formed by coating the ULK dielectric layer with a light-sensitive organic material, applying a light source with a patterned mask over the surface of the wafer substrate which blocks light so that only unmasked regions of the material will be exposed to light, and applying a solvent to develop the material so that photo-sensitive material degraded by light and the developer will dissolve away the regions that were exposed to light, leaving behind a coating where the mask was placed and an via etch opening over the ULK dielectric layer where the coating is removed.

At step 96, a via opening is selectively etched into the ultra low-k dielectric layer using the first photoresist mask. In selected embodiments, the ULK dielectric layer is selectively etched by using the first photoresist mask to perform a reactive-ion etching (RIE) step having suitable etch chemistry properties to selectively etch the via opening by removing the exposed portions of the underlying ULK dielectric layer to a predetermined depth which exposes the underlying M1 layer.

At step 97, a first polyimide layer is formed in the via opening formed in the ultra low-k dielectric layer after removing the first photoresist mask. An example first polyimide layer may be formed with any suitable high-performance polymer material having optical and dielectric properties such that the polymer material is converted to a graphene material in direct response to laser irradiation, and may be deposited to completely fill the via opening using any suitable deposition technique, such as CVD, PECVD, PVD, ALD, AP-CVD, CBD, or any combination(s) of the above. Example polyimide materials include, but are not limited to, fluorinated polyimide (PI-FP, PI-FO and PI-FH) films which may be prepared using a polycondensation reaction method by incorporating p-phenylenediamine (PDA), 4-40-diaminodiphenyl ether (ODA) and 4,40-(Hexafluoroisopropylidene) bis (p-phenyleneoxy) dianiline (HFPBDA) into 4,40-(Hexafluoroisopropylidene) diphthalic anhydride (6FDA), respectively. As understood by those skilled in the art, PI-FP represents 6FDA-PDA, PI-FO represents 6FDA-ODA, and PI-FH represents 6FDA- HFBAPP, respectively. After depositing the first polyimide layer to fill the via opening, a CMP or other planarization step may be applied to the first polyimide layer with the ULK dielectric layer, either directly after forming the first polyimide layer or at a subsequent stage in the fabrication process.

At step 98, a second photoresist mask with a patterned metal line etch opening is formed over the ultra low-k dielectric layer. In selected embodiments, the second photoresist mask is formed by coating the ULK dielectric layer with a light-sensitive organic material, applying a light source with a patterned mask over the surface of the wafer substrate which selectively blocks light, and developing the material to leave a coating where the mask was placed and to leave a metal line etch opening over the ULK dielectric layer where the coating is removed.

At step 99, a metal line opening is selectively etched into the ultra low-k dielectric layer using the second photoresist mask. In selected embodiments, the ULK dielectric layer is selectively etched by using the second photoresist mask to perform a reactive-ion etching (RIE) step having suitable etch chemistry properties to selectively etch the metal line opening by removing the exposed portions of the underlying ULK dielectric layer to a predetermined depth which exposes the underlying first polyimide layer.

At step 100, a second polyimide layer is formed in the metal line opening formed in the ultra low-k dielectric layer after removing the second photoresist mask. In selected embodiments, the second polyimide layer may be formed using any suitable deposition technique, such as CVD, PECVD, PVD, ALD, AP-CVD, CBD, or any combination(s) of the above, to deposit any suitable high-performance polymer material having optical and dielectric properties such that the polymer material is converted to a graphene material in direct response to laser irradiation. Example polyimide materials include, but are not limited to, fluorinated polyimide (PI-FP, PI-FO and PI-FH) films which may be prepared using a polycondensation reaction method by incorporating p-phenylenediamine (PDA), 4-40-diaminodiphenyl ether (ODA) and 4,40-(Hexafluoroisopropylidene) bis (p-phenyleneoxy) dianiline (HFPBDA) into 4,40-(Hexafluoroisopropylidene) diphthalic anhydride (6FDA), respectively. After depositing the second polyimide layer to fill the metal line opening, a CMP or other planarization step may be applied to the first polyimide layer with the ULK dielectric layer, either directly after forming the second polyimide layer or at a subsequent stage in the fabrication process. In other embodiments, the formation of the first and second polyimide layers may be performed in a single polyimide deposition step.

At step 101, a laser is applied to the first and second polyimide layers to form graphene via and metal lines. In selected embodiments, a laser irradiation source, such as an ultraviolet laser, may be employed to directly lase the first and second polyimide layers into 3D porous graphene material. In cases where the first and second polyimide layers have different depth profiles, the application of the laser irradiation source should be controlled to selectively apply the required energy dosage for converting both the first and second polyimide layers into graphene. In other embodiments, a single-inlaid flow could be employed to decouple the laser parameters for the via from the metal line. For example, the first polyimide layer could be deposited and lased to form the conductive graphene via structure, followed by depositing and lasing the second polyimide layer to form the conductive graphene wiring line structure. In other embodiments, the planarization of the graphene wiring line structure can occur after lasing the second polyimide layer to form the graphene wiring line structure. In still other embodiments, the planarization of the graphene wiring line structure can by depositing photo-imageable polyimide and controlling the light exposure so that the upper polyimide is exposed and then selectively removed with a development process, leaving polyimide that is coplanar with the top of the ILD so that no CMP planarization would be needed.

At step 102, the fabrication process flow ends, though it will be appreciated that additional back-end-of-line processing may occur to complete the fabrication of the integrated circuit structure, such as packaging, scribe cuts, die separation, testing, etc.

As described hereinabove, the present disclosure provides a mechanism for integrating graphene interconnects into ultra-low k dielectric layers with an exceptionally planar BEOL flow which does not need special metal, barrier, or liner layers for graphene contacts, and which circumvents the most complex and costly BEOL operations while providing the highest known conductivity. In addition to reducing fabrication cost and complexity, the disclosed mechanism for integrating graphene interconnects provides advantages to reliability and yield by reducing or eliminating stress migration, electromigration, or plasma induced damage.

By now, it should be appreciated that there has been provided an integrated circuit interconnect device and associated method of fabrication. In the disclosed methodology, an integrated circuit structure is provided that includes a first dielectric layer formed over a first conductive contact layer. In selected embodiments, the integrated circuit structure is provided with a semiconductor substrate on which is formed a plurality of integrated circuit elements covered by the first dielectric layer. In selected embodiments, the first dielectric layer includes an ultra low-k dielectric layer and the first conductive contact layer includes a graphene contact layer. The disclosed methodology also includes forming an interconnect opening in the first dielectric layer which exposes at least a portion of the first conductive contact layer. In selected embodiments, the interconnect opening is formed in the first dielectric layer by patterning a first resist material on the first dielectric layer to form a first resist mask with a via opening over the first dielectric layer, selectively etching the via opening in the first dielectric layer using the first resist mask, patterning a second resist material on the first dielectric layer to form a second resist mask with a metal line opening over the first dielectric layer, and selectively etching the metal line opening in the first dielectric layer using the second resist mask. In addition, the disclosed methodology includes filling interconnect opening in the first dielectric layer with polyimide in contact the first conductive contact layer. In selected embodiments, the interconnect opening is filled by filling the via opening in the first dielectric layer with polyimide using a first deposition process before patterning the second resist material, and then filling the metal line opening in the first dielectric layer with polyimide using a second deposition process after selectively etching the metal line opening. In other embodiments, the interconnect opening is filled by filling the via opening and the metal line opening in the first dielectric layer with polyimide using a deposition process after selectively etching the metal line opening. The disclosed methodology also includes applying a laser light source to directly convert the polyimide to form a graphene interconnect structure in the first dielectric layer which is directly, electrically connected to the first conductive contact layer. In selected embodiments, a laser irradiation source is applied to one or more first polyimide layers located in the via opening to form a graphene via structure in the first dielectric layer in direct electrical contact with the first conductive contact layer, and a laser irradiation source is applied to one or more second polyimide layers located in the metal line opening to form a graphene wiring line structure in the first dielectric layer which is in direct electrical contact with the graphene via structure.

In another form, there has been provided a graphene interconnect structure and associated method of fabrication. In the disclosed methodology, a first conductive layer is formed over a first dielectric layer. In selected embodiments, the first conductive layer is formed with a first graphene layer on the first dielectric layer which covers a plurality of integrated circuit elements formed on a semiconductor substrate. The disclosed methodology also includes forming a second dielectric layer over the first conductive layer. In selected embodiments, the second dielectric layer is formed by depositing and planarizing an ultra-low-k dielectric layer over the first conductive layer. In other selected embodiments, the second dielectric layer is formed with amorphous fluorinated diamond-like carbon (a-C:F). In selected embodiments, the ultra-low-k dielectric layer is fluorinated amorphous diamond-like carbon. In addition, the disclosed methodology includes forming a via etch opening in the second dielectric layer which exposes at least a portion of the first conductive layer. In selected embodiments, the via etch opening is formed in the second dielectric layer by patterning a first resist material on the second dielectric layer to form a first resist mask with a via opening over the second dielectric layer; and selectively etching the via etch opening in the second dielectric layer using the via opening in the first resist mask. The disclosed methodology also includes forming a wiring line etch opening in an upper portion of the second dielectric layer having a portion which overlaps with the via etch opening. In selected embodiments, the wiring line etch opening is formed in the upper portion of the second dielectric layer by patterning a second resist material on the second dielectric layer to form a second resist mask with a wiring line opening over the second dielectric layer; and selectively etching the wiring line etch opening in the second dielectric layer using the wiring line opening in the second resist mask. In addition, the disclosed methodology includes forming one or more polyimide layers to fill the via etch opening and the wiring line etch opening in the second dielectric layer. In selected embodiments, the one or more polyimide layers are formed by filling the via etch opening and the wiring line etch opening in the second dielectric layer with one or more first polyimide layers using a first deposition process; and planarizing the one or more first polyimide layers with a top surface of the second dielectric layer. The disclosed methodology also includes applying irradiation from a laser source to directly convert the one or more polyimide layers into the graphene interconnect structure comprising a graphene wiring line formed in the wiring line etch opening and a graphene via structure formed in the via etch opening to directly, electrically connect the graphene wiring line to the first conductive layer. In selected embodiments, irradiation from a laser source is applied by applying a laser irradiation source to one or more first polyimide layers located in the via etch opening to form the graphene via structure in the second dielectric layer in direct electrical contact with the first conductive layer; and applying a laser irradiation source to one or more second polyimide layers located in the wiring line etch opening to form the graphene wiring line structure in the second dielectric layer which is in direct electrical contact with the graphene via structure. In other embodiments, irradiation from a femto-second UV laser source is applied to directly convert the one or more polyimide layers into the graphene interconnect structure. In selected embodiments, the disclosed methodology also includes planarizing the graphene wiring line with a top surface of the second dielectric layer.

In yet another form, there has been provided an integrated circuit and associated method of fabrication. As disclosed, the integrated circuit includes a substrate having one or more semiconductor devices formed therein. In addition, the semiconductor device includes a multi-layer interconnect stack formed over the substrate to include a plurality of stacked wiring lines that are vertically separated from one another by a corresponding plurality of interlayer dielectric (ILD) layers. In particular, the multi-layer interconnect stack includes a first graphene wiring line in a first conductor layer, a second graphene wiring line in a second conductor layer that is separated from the first graphene wiring line by a first ILD layer, and a first graphene via structure formed in the first ILD layer to electrically connect the first graphene wiring line to the second graphene wiring line. Each of the first graphene wiring line, second graphene wiring line, and first graphene via structure are formed as an irradiation-induced graphene structure which does not include an underlying metal layer. In selected embodiments, the first graphene wiring line, second graphene wiring line, and first graphene via structure are each formed as a laser-induced graphene foam structure. In other selected embodiments, the first ILD layer is formed with amorphous fluorinated diamond-like carbon (a-C:F).

As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. A method for making an integrated circuit interconnect device, comprising:
providing an integrated circuit structure comprising a first dielectric layer formed over a first conductive contact layer;
forming an interconnect opening in the first dielectric layer which exposes at least a portion of the first conductive contact layer;
filling the interconnect opening in the first dielectric layer with polyimide in contact the first conductive contact layer; and
applying a laser light source to directly convert the polyimide to form a graphene interconnect structure in the first dielectric layer, which is directly electrically connected to the first conductive contact layer.

2. The method of claim 1, where providing the integrated circuit structure comprises providing a semiconductor substrate on which is formed a plurality of integrated circuit elements covered by the first dielectric layer.

3. The method of claim 1 or 2, where the first dielectric layer comprises an ultra low-k dielectric layer and where the first conductive contact layer comprises a graphene contact layer.

4. The method of any preceding claim 1, where forming the interconnect opening in the first dielectric layer comprises:
patterning a first resist material on the first dielectric layer to form a first resist mask with a via opening over the first dielectric layer;
selectively etching the via opening in the first dielectric layer using the first resist mask;
patterning a second resist material on the first dielectric layer to form a second resist mask with a metal line opening over the first dielectric layer; and
selectively etching the metal line opening in the first dielectric layer using the second resist mask.

5. The method of claim 4, where filling the interconnect opening comprises:
filling the via opening in the first dielectric layer with polyimide using a first deposition process before patterning the second resist material; and
filling the metal line opening in the first dielectric layer with polyimide using a second deposition process after selectively etching the metal line opening.

6. The method of claim 4 or 5, where filling the interconnect opening comprises:
filling the via opening and the metal line opening in the first dielectric layer with polyimide using a deposition process after selectively etching the metal line opening.

7. The method of any of claims 4 to 6, where applying the laser light source comprises:
applying a laser irradiation source to the polyimide located in the via opening to form a graphene via structure in the first dielectric layer in direct electrical contact with the first conductive contact layer; and
applying a laser irradiation source to the polyimide located in the metal line opening to form a graphene wiring line structure in the first dielectric layer which is in direct electrical contact with the graphene via structure.

8. The method of claim 3, or any of claims 4 to 7 when depending from claim 3, where the ultra-low-k dielectric layer comprises fluorinated amorphous diamond-like carbon.

9. The method of any preceding claim, where applying irradiation from a laser source comprises:
applying irradiation from a femto-second UV laser source to directly convert the one or more polyimide layers into the graphene interconnect structure.

10. The method of any preceding claim, further comprising planarizing the graphene wiring line with a top surface of the second dielectric layer.

11. The method of any preceding claim, further comprising forming a second dielectric layer over the first conductive layer, and wherein forming the second dielectric layer comprises forming amorphous fluorinated diamond-like carbon (a-C:F).

12. An integrated circuit, comprising:
a substrate comprising one or more semiconductor devices formed therein; and
a multi-layer interconnect stack formed over the substrate comprising a plurality of stacked wiring lines that are vertically separated from one another by a corresponding plurality of interlayer dielectric, ILD, layers, the multi-layer interconnect stack comprising:
a first graphene wiring line in a first conductor layer,
a second graphene wiring line in a second conductor layer that is separated from the first graphene wiring line by a first ILD layer, and
a first graphene via structure formed in the first ILD layer to electrically connect the first graphene wiring line to the second graphene wiring line;
where the first graphene wiring line, second graphene wiring line, and first graphene via structure each comprise an irradiation-induced graphene structure which does not include an underlying metal layer.

13. The semiconductor device of claim 18, where the first graphene wiring line, second graphene wiring line, and first graphene via structure each comprise a laser-induced graphene foam structure.

14. The semiconductor device of claim 18, where the first ILD layer comprises amorphous fluorinated diamond-like carbon, a-C:F.

## Patentansprüche

1. Verfahren zum Herstellen einer integrierte-Schaltung-Interconnect-Vorrichtung, umfassend:
Bereitstellen einer integrierte-Schaltung-Struktur, umfassend eine erste dielektrische Schicht, die über einer ersten leitfähigen Kontaktschicht gebildet ist;
Bilden einer Interconnect-Öffnung in der ersten dielektrischen Schicht, die mindestens einen Teil der ersten leitfähigen Kontaktschicht freilegt;
Füllen der Interconnect-Öffnung in der ersten dielektrischen Schicht mit Polyimid in Kontakt mit der ersten leitfähigen Kontaktschicht; und
Anwenden einer Laserlichtquelle zum direkten Umwandeln des Polyimids, um eine Graphen-Interconnect-Struktur in der ersten dielektrischen Schicht zu bilden, die direkt elektrisch mit der ersten leitfähigen Kontaktschicht verbunden ist.

2. Verfahren nach Anspruch 1, wobei Bereitstellen der integrierte-Schaltung-Struktur Bereitstellen eines Halbleitersubstrats umfasst, auf dem eine Vielzahl von integrierte-Schaltung-Elementen gebildet ist, die durch die erste dielektrische Schicht bedeckt ist.

3. Verfahren nach Anspruch 1 oder 2, wobei die erste dielektrische Schicht eine dielektrische Ultra-Low-k-Schicht umfasst, und wobei die erste leitfähige Kontaktschicht eine Graphen-Kontaktschicht umfasst.

4. Verfahren nach Anspruch 1, wobei Bilden der Interconnect-Öffnung in der ersten dielektrischen Schicht umfasst:
Strukturieren eines ersten Resistmaterials auf der ersten dielektrischen Schicht, um eine erste Resistmaske mit einer Via-Öffnung über der ersten dielektrischen Schicht zu bilden;
selektives Ätzen der Via-Öffnung in der ersten dielektrischen Schicht unter Verwendung der ersten Resistmaske;
Strukturieren eines zweiten Resistmaterials auf der ersten dielektrischen Schicht, um eine zweite Resistmaske mit einer Metallleitungsöffnung über der ersten dielektrischen Schicht zu bilden; und
selektives Ätzen der Metallleitungsöffnung in der ersten dielektrischen Schicht unter Verwendung der zweiten Resistmaske.

5. Verfahren nach Anspruch 4, wobei Füllen der Interconnect-Öffnung umfasst:
Füllen der Via-Öffnung in der ersten dielektrischen Schicht mit Polyimid unter Verwendung eines ersten Abscheidungsprozesses vor Strukturieren des zweiten Resistmaterials; und
Füllen der Metallleitungsöffnung in der ersten dielektrischen Schicht mit Polyimid unter Verwendung eines zweiten Abscheidungsprozesses nach selektivem Ätzen der Metallleitungsöffnung.

6. Verfahren nach Anspruch 4 oder 5, wobei Füllen der Interconnect-Öffnung umfasst:
Füllen der Via-Öffnung und der Metallleitungsöffnung in der ersten dielektrischen Schicht mit Polyimid unter Verwendung eines Abscheidungsprozesses nach selektivem Ätzen der Metallleitungsöffnung.

7. Verfahren nach einem der Ansprüche 4 bis 6, wobei Anwenden der Laserlichtquelle umfasst:
Anwenden einer Laserbestrahlungsquelle auf das Polyimid, das sich in der Via-Öffnung befindet, um eine Graphen-Via-Struktur in der ersten dielektrischen Schicht in direktem elektrischem Kontakt mit der ersten leitfähigen Kontaktschicht zu bilden; und
Anwenden einer Laserbestrahlungsquelle auf das Polyimid, das sich in der Metallleitungsöffnung befindet, um eine Graphen-Verdrahtungsleitungsstruktur in der ersten dielektrischen Schicht zu bilden, die in direktem elektrischem Kontakt mit der Graphen-Via-Struktur ist.

8. Verfahren nach Anspruch 3 oder einem der Ansprüche 4 bis 7 in Abhängigkeit von Anspruch 3, wobei die dielektrische Ultra-Low-k-Schicht fluorierten amorphen diamantähnlichen Kohlenstoff umfasst.

9. Verfahren nach einem der vorhergehenden Ansprüche, wobei Anwenden von Bestrahlung von einer Laserquelle umfasst:
Anwenden von Bestrahlung von einer Femtosekunden-UV-Laserquelle, um die eine oder mehreren Polyimidschichten direkt in die Graphen-Interconnect-Struktur umzuwandeln.

10. Verfahren nach einem der vorhergehenden Ansprüche, ferner umfassend Planarisieren der Graphen-Verdrahtungsleitung mit einer oberen Oberfläche der zweiten dielektrischen Schicht.

11. Verfahren nach einem der vorhergehenden Ansprüche, ferner umfassend Bilden einer zweiten dielektrischen Schicht über der ersten leitfähigen Schicht, und wobei Bilden der zweiten dielektrischen Schicht Bilden von amorphem fluoriertem diamantähnlichem Kohlenstoff (a-C:F) umfasst.

12. Integrierte Schaltung, umfassend:
ein Substrat, umfassend eine oder mehrere darin gebildete Halbleitervorrichtungen; und
einen mehrschichtigen Interconnect-Stapel, der über dem Substrat gebildet ist, umfassend eine Vielzahl von gestapelten Verdrahtungsleitungen, die durch eine entsprechende Vielzahl von Zwischenschicht-Dielektrikum-, ILD-, Schichten vertikal voneinander getrennt ist, wobei der mehrschichtige Interconnect-Stapel umfasst:
eine erste Graphen-Verdrahtungsleitung in einer ersten Leiterschicht,
eine zweite Graphen-Verdrahtungsleitung in einer zweiten Leiterschicht, die von der ersten Graphen-Verdrahtungsleitung durch eine erste ILD-Schicht getrennt ist, und
eine erste Graphen-Via-Struktur, die in der ersten ILD-Schicht gebildet ist, um die erste Graphen-Verdrahtungsleitung elektrisch mit der zweiten Graphen-Verdrahtungsleitung zu verbinden;
wobei die erste Graphen-Verdrahtungsleitung, die zweite Graphen-Verdrahtungsleitung und die erste Graphen-Via-Struktur jeweils eine strahlungsinduzierte Graphen-Struktur umfassen, die keine darunterliegende Metallschicht einschließt.

13. Halbleitervorrichtung nach Anspruch 18, wobei die erste Graphen-Verdrahtungsleitung, die zweite Graphen-Verdrahtungsleitung und die erste Graphen-Via-Struktur jeweils eine laserinduzierte Graphen-Schaumstruktur umfassen.

14. Halbleitervorrichtung nach Anspruch 18, wobei die erste ILD-Schicht amorphen fluorierten diamantähnlichen Kohlenstoff a-C:F umfasst.

## Revendications

1. Procédé destiné à fabriquer un dispositif d'interconnexion de circuit intégré, comprenant :
l'obtention d'une structure de circuit intégré comprenant une première couche diélectrique formée sur une première couche de contact conductrice ;
la formation d'une ouverture d'interconnexion dans la première couche diélectrique qui expose au moins une partie de la première couche de contact conductrice ;
le remplissage de l'ouverture d'interconnexion dans la première couche diélectrique avec du polyimide en contact avec la première couche de contact conductrice ; et
l'application d'une source de lumière laser pour transformer directement le polyimide afin de former une structure d'interconnexion en graphène dans la première couche diélectrique, qui est directement reliée électriquement à la première couche de contact conductrice.

2. Procédé de la revendication 1, dans lequel l'obtention de la structure de circuit intégré comprend l'obtention d'un substrat semi-conducteur sur lequel est formée une pluralité d'éléments de circuit intégré recouverts par la première couche diélectrique.

3. Procédé de la revendication 1 ou 2, dans lequel la première couche diélectrique comprend une couche diélectrique à k ultrafaible et dans lequel la première couche de contact conductrice comprend une couche de contact en graphène.

4. Procédé de la revendication 1, dans lequel la formation de l'ouverture d'interconnexion dans la première couche diélectrique comprend :
la formation d'un motif dans un premier matériau en résine photosensible sur la première couche diélectrique pour former un premier masque de résine photosensible avec une ouverture de trou d'interconnexion sur la première couche diélectrique ;
la gravure sélective de l'ouverture de trou d'interconnexion dans la première couche diélectrique au moyen du premier masque de résine photosensible ;
la formation d'un motif dans un deuxième matériau en résine photosensible sur la première couche diélectrique pour former un deuxième masque de résine photosensible avec une ouverture de ligne métallique sur la première couche diélectrique ; et
la gravure sélective de l'ouverture de ligne métallique dans la première couche diélectrique au moyen du deuxième masque de résine photosensible.

5. Procédé de la revendication 4, dans lequel le remplissage de l'ouverture d'interconnexion comprend :
le remplissage de l'ouverture de trou d'interconnexion dans la première couche diélectrique avec du polyimide au moyen d'un premier procédé de dépôt avant la formation du motif du deuxième matériau en résine photosensible ; et
le remplissage de l'ouverture de ligne métallique dans la première couche diélectrique avec du polyimide au moyen d'un deuxième procédé de dépôt après la gravure sélective de l'ouverture de ligne métallique.

6. Procédé de la revendication 4 ou 5, dans lequel le remplissage de l'ouverture d'interconnexion comprend :
le remplissage de l'ouverture de trou d'interconnexion et de l'ouverture de ligne métallique dans la première couche diélectrique avec du polyimide au moyen d'un procédé de dépôt après la gravure sélective de l'ouverture de ligne métallique.

7. Procédé de l'une quelconque des revendications 4 à 6, dans lequel l'application de la source de lumière laser comprend :
l'application d'une source d'irradiation laser au polyimide situé dans l'ouverture de trou d'interconnexion pour former une structure de trou d'interconnexion en graphène dans la première couche diélectrique en contact électrique direct avec la première couche de contact conductrice ; et
l'application d'une source d'irradiation laser au polyimide situé dans l'ouverture de ligne métallique pour former une structure de ligne de câblage en graphène dans la première couche diélectrique qui est en contact électrique direct avec la structure de trou d'interconnexion en graphène.

8. Procédé de la revendication 3, ou de l'une quelconque des revendications 4 à 7 lorsqu'elles sont dépendantes de la revendication 3, dans lequel la couche diélectrique à k ultrafaible comprend du carbone de type diamant amorphe fluoré.

9. Procédé d'une quelconque revendication précédente, dans lequel l'application d'une irradiation depuis une source laser comprend :
l'application d'une irradiation depuis une source laser UV femtoseconde pour transformer directement la ou les couches de polyimide en structure d'interconnexion en graphène.

10. Procédé d'une quelconque revendication précédente, comprenant en outre la planarisation de la ligne de câblage en graphène avec une surface supérieure de la deuxième couche diélectrique.

11. Procédé d'une quelconque revendication précédente, comprenant en outre la formation d'une deuxième couche diélectrique sur la première couche conductrice, et dans lequel la formation de la deuxième couche diélectrique comprend la formation de carbone de type diamant amorphe fluoré (a-C:F).

12. Circuit intégré, comprenant :
un substrat comprenant un ou plusieurs dispositifs semiconducteurs formés en son sein ; et
un empilement d'interconnexion multicouche formé sur le substrat comprenant une pluralité de lignes de câblage empilées qui sont séparées verticalement les unes des autres par une pluralité correspondante de couches de diélectrique intercouche, ILD, l'empilement d'interconnexion multicouche comprenant :
une première ligne de câblage en graphène dans une première couche conductrice,
une deuxième ligne de câblage en graphène dans une deuxième couche conductrice qui est séparée de la première ligne de câblage en graphène par une première couche ILD, et
une première structure de trou d'interconnexion en graphène formée dans la première couche ILD pour relier électriquement la première ligne de câblage en graphène à la deuxième ligne de câblage en graphène ;
dans lequel la première ligne de câblage en graphène, la deuxième ligne de câblage en graphène et la première structure de trou d'interconnexion en graphène comprennent chacune une structure de graphène induite par irradiation qui ne comporte pas de couche métallique sous-jacente.

13. Dispositif semi-conducteur de la revendication 18, dans lequel la première ligne de câblage en graphène, la deuxième ligne de câblage en graphène et la première structure de trou d'interconnexion en graphène comprennent chacune une structure de mousse de graphène induite par laser.

14. Dispositif semi-conducteur de la revendication 18, dans lequel la première couche ILD comprend du carbone de type diamant amorphe fluoré, a-C:F.
